Europäisches Patentamt

European Patent Office

Office européen des brevets

(19)

(11) **EP 0 640 223 B1**

(12) **EUROPÄISCHE PATENTSCHRIFT**

(45) Veröffentlichungstag und Bekanntmachung des Hinweises auf die Patenterteilung:
**04.02.1998  Patentblatt 1998/06**

(21) Anmeldenummer: **94916820.7**

(22) Anmeldetag: **27.11.1993**

(51) Int Cl.[6]: **G02B 6/42**, G02B 6/28, G02B 6/12

(86) Internationale Anmeldenummer:
**PCT/DE93/01128**

(87) Internationale Veröffentlichungsnummer:
**WO 94/12903 (09.06.1994 Gazette 1994/13)**

(54) **VERFAHREN ZUR HERSTELLUNG VON OPTISCHEN POLYMERELEMENTEN MIT INTEGRIERTEN VERTIKALEN KOPPLUNGSSTRUKTUREN**

PROCESS FOR PRODUCING OPTICAL POLYMER COMPONENTS WITH INTEGRATED VERTICAL COUPLING STRUCTURES

METHODE DE FABRICATION DE COMPOSANTS OPTIQUES POLYMERES AVEC STRUCTURES DE COUPLAGE VERTICALES

(84) Benannte Vertragsstaaten:
**DE FR GB IT NL**

(30) Priorität: **01.12.1992  DE 4240266**

(43) Veröffentlichungstag der Anmeldung:
**01.03.1995  Patentblatt 1995/09**

(73) Patentinhaber: **ROBERT BOSCH GMBH
70442 Stuttgart (DE)**

(72) Erfinder: **MAYER, Klaus-Michael
D-70839 Gerlingen (DE)**

(56) Entgegenhaltungen:
**US-A- 5 165 001**

- **ELECTRONICS & COMMUNICATIONS IN JAPAN, PART I - COMMUNICATIONS Bd. 66, Nr. 2, Februar 1983, New York, US, SS 106-110; I. KATO ET AL.: 'Multistructured Optical IC Elements by Polymer Thin Films'**
- **PATENT ABSTRACTS OF JAPAN vol. 8, no. 248 (P-313)(1685) 14. November 1984 & JP-A-59 121 008**
- **40th Electronic Components & Technology Conference, Las Vegas, Nevada, 20.-23. Mai 1990, M.J. Wale: 'Self Aligned, Flip Chip Assembly of Photonic Devices with Electrical and Optical Connections'**
- **PATENT ABSTRACTS OF JAPAN vol. 13, no. 329 (P-904) 25. Juli 1989 & JP-A-01 094 305**
- **NTC-92, Washington D.C., USA, 19.-20. Mai 1992, N.P. Vlannes: 'ORGANIC PHOTONICS: A MATERIALS and DEVICES STRATEGY for COMPUTATIONAL and COMMUNICATIONS SYSTEMS'**

**Beschreibung**

Die Erfindung betrifft ein Verfahren zur Herstellung eines optischen Polymerbauelements und findet Anwendung bei der massenweisen Produktion von monomodigen oder multimodigen Bauelementen, insbesondere bei opto-optischen Bauelementen, der integrierten Optik mit monolithisch integrierter Faser-Chip-Kopplung.

Der zunehmende Einsatz integriert-optischer Komponenten für die optische Nachrichtentechnik, für die Sensorik und den Computerbereich (optischer Datenbus) läßt der optischen Anschlußtechnik (Chip-Faser-Kopplung) und der optischen Koppeltechnik eine immer größere Bedeutung zukommen. Bereits kleinere private Vermittlungsstellen mit etwa 1.000 Teilnehmeranschlüssen benötigen dabei beispielsweise mehrere tausend optische Anschlüsse und Koppelstellen zwischen den einzelnen Subschaltstufen, da Anzahl und Komplexität der auf einzelnen Substraten integrierten optischen Komponenten aufgrund der extremen Aspektverhältnisse in der Optik stark eingeschränkt ist. In solchen Anwendungsfällen bestimmt die Realisierbarkeit und Zuverlässigkeit (mechanische und thermische Stabilität) der optischen Anschluß- und Koppeltechnik und der erforderliche Anschlußaufwand letztlich den erreichbaren Ausbaugrad eines optischen Vermittlungssystems.

Die grundsätzliche Funktionsweise vertikaler Richtkoppler, bei denen zwei übereinanderliegende Lichtwellenleiter über eine definierte Länge einander so nahe kommen, daß eine Kopplung zwischen ihnen stattfindet und Energie ausgetauscht werden kann, ist bekannt. Üblicherweise werden solche Bauelemente in übereinander aufgeschichtete, dünne Filme (Filmwellenleiter) strukturiert, wobei die zwischen den Wellenleitern liegende Schicht durch ihre optische Dicke die Koppelstärke der Wellenleiter bestimmt. Die Homogenität dieser Zwischenschicht ist damit kritisch für die Funktionsweise solcher Bauelemente und technologisch schwer beherrschbar. Ferner ist bisher weder eine selbstjustierende optische Anschlußtechnik für solche auf verschiedenen Höhen liegende Wellenleiter noch eine spritzgußtechnische Massenproduzierbarkeit solcher Bauelemente möglich.

Bei bekannten Parallelstreifenkopplern müssen üblicherweise koplanare Wellenleiter im Koppelbereich mit wenigen μm lateralem Abstand über einige hundert μm Koppellänge präzise nebeneinander her geführt werden. Solche Strukturen sind spritzgußtechnisch schwierig zu realisieren, da sehr schmale Stege zwischen Grabenstrukturen für die Wellenleiter zu fertigen wären.

Von H. Hosokawa et al., in Integrated Photonics Research Conf., (1991) sind sogenannte Prägetechniken für monomodige Lichtwellenleiter in Kunststoffen ("embossing" oder Photopolymerisation) bekannt. Jedoch ist weder eine übereinanderliegende Anordnung von Wellenleiterkoppelstrukturen noch die gleichzeitige Herstellung einer substratintegrierten Faserführung in dieser Technik möglich.

Weiterhin sind von A. Neyer et al., in Integrated Photonics Research Conf., (1992) bekannt, Wellenleiterstrukturen in einem Substrat abzuformen und diese dann mit einem, einen höheren Brechungsindex aufweisenden lichtführenden Polymer zu füllen. Hierbei können lediglich nur einseitig in einer Substratschicht Wellenleiter geschaffen werden, jedoch eine übereinanderliegende Anordnung von Wellenleiterkoppelstrukturen ist ausgeschlossen.

Darüber hinaus ist das Prinzip der galvanischen Abformtechnik und Spritzgußvervielfältigung von Mikrostrukturen als sogen. "LIGA"-Technik bekannt. Hier werden die abzuformenden Primärstrukturen üblicherweise durch Röntgenbelichtung von Kunststoffen am Synchotron erzeugt und davon galvanisch die Formeinsätze für den Spritzguß erstellt. Eine abwechselnde Anordnung von höherliegenden und tieferliegenden Faserführungsstrukturen, wie sie für vertikale Koppelelemente notwendig werden, ist nach dem derzeitigen Stand in der LIGA-Technik nicht möglich, da die notwendige Röntgenbelichtung prinzipiell keine Tiefenauflösung ermöglicht.

Vorteile der Erfindung

Das erfindungsgemäße Verfahren ist in Anspruch 1 definiert. Ein erfindungsgemäßes Polymerbauelement ist in Anspruch 17 definiert. Das erfindungsgemäße Verfahren bietet den Vorteil, daß eine massenhafte Produktion von Polymerbauelementen mit integrierten vertikalen Koppelstrukturen mit hoher Koppelgenauigkeit in einfacher Weise möglich ist.

Hierbei können nach vorliegender Erfindung sowohl passive als auch optooptisch-aktive oder akustooptische Bauelemente der Integrierten Optik mit monolithisch integrierter Faser-Chip-Kopplung massenproduzierbar gefertigt werden.

Dazu ist vorgesehen, daß auf der Substratplatte und der Deckelplatte jeweils wenigstens eine Struktur zur Aufnahme eines Lichtwellenleiters und jeweils wenigstens zwei Faserführungsstrukturen sowie jeweils wenigstens zwei Justagestrukturen derart hergestellt werden, daß sowohl die Substratplatte als auch die Deckelplatte Faserführungsstrukturen besitzen, denen nach der Montage, gegenüberliegend in der Substratplatte bzw. Deckelplatte die Justagestrukturen zugeordnet sind und die die Faserführungsstrukturen verbindenden Lichtwellenleiterstrukturen der Substratplatte und der Deckelplatte in wenigstens einem Bereich parallel zueinander verlaufen.

Weitere vorteilhafte Ausgestaltungen ergeben sich aus den in den Unteransprüchen angegebenen Maßnahmen.

In einfacher Weise werden durch bekannte anisotrope Ätztechniken des Siliciums V-förmige Grabenstrukturen in {100} orientierte Wafer, die die Substratplatte und die Deckelplatte ergeben, geätzt, wobei sich eine hochpräzise Struktur ergibt, über die die spätere genaue Lage von Glasfaser- und Wellenleiterstruktur zueinander definiert ist.

Eine solche V-Nut ist als Faserführungsstruktur und Justagestruktur besonders geeignet, da die Winkeljustage, parallel zur Kristalloberfläche, sich automatisch einstellt und über die Öffnungsweite der V-Nut sich die Höhenlage des Faserkerns über die Waferoberfläche exakt einstellen und fertigungstechnisch kontrollieren läßt.

In vorteilhafter Weise werden die V-Nuten mit polymeren Materialien aufgefüllt und die entstandene ebene Oberfläche anschließend mit einem Photolack oder einem anderen strukturierbaren Polymer beschichtet. In die so entstandene Deckschicht werden grabenförmige Öffnungen strukturiert, die die Abmessungen der späteren Lichtwellenleiter definieren.

Weiterhin werden die V-Nuten anschließend mittels an sich bekannter Excimer-Laserablationstechnik wieder geöffnet und in besonders vorteilhafter Weise senkrechte Faserstrukturanschläge am lichtwellenleiterseitigen Ende der V-Nuten geschnitten.

In weiterer vorteilhafter Ausgestaltung der Erfindung ist vorgesehen, daß die Masterstrukturen aus Lichtwellenleiter-Vorstrukturen und integrierten Faserführungsstrukturen sowie Justagestrukturen durch an sich bekannte Galvanikverfahren abgeformt werden.

Die so entstandene Negativfom wird zur Herstellung zahlreicher Tochterkopien der Masterstruktur verwendet. Dies erfolgt vorteilhafterweise durch Spritzguß- oder Spritzprägeverfahren im Polymermaterial.

Erfindungsgemäß werden die grabenförmigen, später die Lichtwellenleiter ergebenden Öffnungen, so strukturiert, daß sie jeweils zwei sich in der Substratplatte bzw. Deckelplatte gegenüberliegende Faserführungsstrukturen verbinden, wobei sie wenigstens einen Bereich aufweisen, in dem die Öffnung für den substratplattenseitigen Lichtwellenleiter nach der Montage vertikal beabstandet, parallel zu der Öffnung für den deckelplattenseitigen Lichtwellenleiter verläuft.

Durch den intrinsischen Aufbau des Bauelements mit vertikalen Kopplerstrukturen anstelle koplanar nebeneinanderliegender Koppelarme (die übliche Ausbildungsform von Richtkoppelbauelementen) ist es insbesondere möglich, unterschiedliche Materialien in die unteren und die oberen, die Lichtwellenleiter ergebenden Öffnungen einzufüllen. Dadurch können beispielsweise unerwünschte Dämpfungsverluste eines besonderen opto-optisch aktiven Materials in der anderen optischen Verbindungsebene vermieden werden oder durch unterschiedliche opto-optisch schaltfähige Substanzen getrennte Schalteffekte durch Steuerlichtstrahlen unterschiedlicher Wellenlängen unten und oben (polymere Substratplatte und polymere Deckelplatte) erreicht werden. Prinzipiell kann das Steuerlicht dazu auch in dem selben Lichtwellenleiter (Faser) geführt werden wie das zu schaltende Signallicht.

In vorteilhafter Weise ist ein Verfahren zum massenproduktionstauglichen Aufbau verschiedener Polymerbauelemente mit vertikalen Koppelstrukturen, welche sowohl für passive Bauelemente, wie beispielsweise 2x2-Richtkoppler oder Sternkoppler/Leistungsteiler in Betracht kommen, wie auch für optisch-gesteuerte optische Schaltelemente mit zweilagigem optischem Aufbau vorgeschlagen worden. Besonders vorteilhaft ist die chipintegrierte gleichzeitige Herstellung von Faserführungsstrukturen für eine selbstjustierende optische Kontaktierung der Koppelbauelemente auf zwei verschiedenen Ebenen.

Ferner ist die selbstjustierende Justagetechnik bei der Montage der Bauelemente vorteilhaft, bei der nicht nur die Fasern passiv an die Lichtwellenleiter justiert werden, sondern auch die polymeren Deckel- und Bodenplatten (Substratplatten) zueinander paßgenau "einrasten". Durch die vertikale Anordnung der Lichtwellenleiter kann der Koppelabstand aller Bauelemente eines Chips technologisch einfach beherrschbar durch die Dicke der eingearbeiteten Polymerfolie kontrolliert werden.

Die freie Kombinierbarkeit verschiedener Core-Polymere in der unteren und der oberen Ebene des Bauelements kann zu vielfältigen Anwendungen genutzt werden, indem beispielsweise mindestens eines der Polymere mit $\chi^{(3)}$-Materialien dotiert wird, um optische Schaltfunktionen zu erzielen.

Weiterhin vorteilhaft kann die eingelegte Polymerfolie selbst auch eine Schaltfunktion bewirken, indem akustooptische Effekte, beispielsweise in einer piezoelektrischen Folie (PVDF-Folie), zu einer Anpassung der Ausbreitungskonstanten des Lichtes in unterschiedlich dimensionierten Lichtwellenleitern unten und oben führen und so ein durch akustische Phononenabsorption induziertes Umschaltverhalten der Koppler auslösen.

Zeichnung

Ausführungsbeispiele der Erfindung sind in den Zeichnungen dargestellt und in der nachfolgenden Beschreibung näher erläutert.

Es zeigen:

Figur 1        einen Querschnitt einer Masterstruktur für eine Faserführungsstruktur;

Figur 2        eine Seitenansicht gemäß Figur 1;

Figur 3        eine Negativform für eine Faserführungsstruktur;

Figur 4        eine Seitenansicht gemäß Figur 3;

Figur 5        einen Ausschnitt aus einem polymeren Bauelement, hergestellt mit einer, der in den Figuren 3 und 4 dargestellten Negativform;

Figur 6 eine Seitenansicht gemäß Figur 5;

Figur 7 eine Projektionsdraufsicht auf ein komplettes polymeres Bauelement;

Figur 8 einen Schnitt entlang der Linie A - A aus Figur 7;

Figur 9 einen Schnitt entlang der Linie B - B aus Figur 7;

Figur 10 einen Schnitt entlang der Linie C - C aus Figur 7;

Figur 11 eine Koppelstruktur im Detail;

Figur 12 eine Projektionsdraufsicht auf ein weiteres polymeres Bauelement und

Figur 13 eine Projektionsdraufsicht auf ein weiteres polymeres Bauelement.

Beschreibung der Ausführungsbeispiele

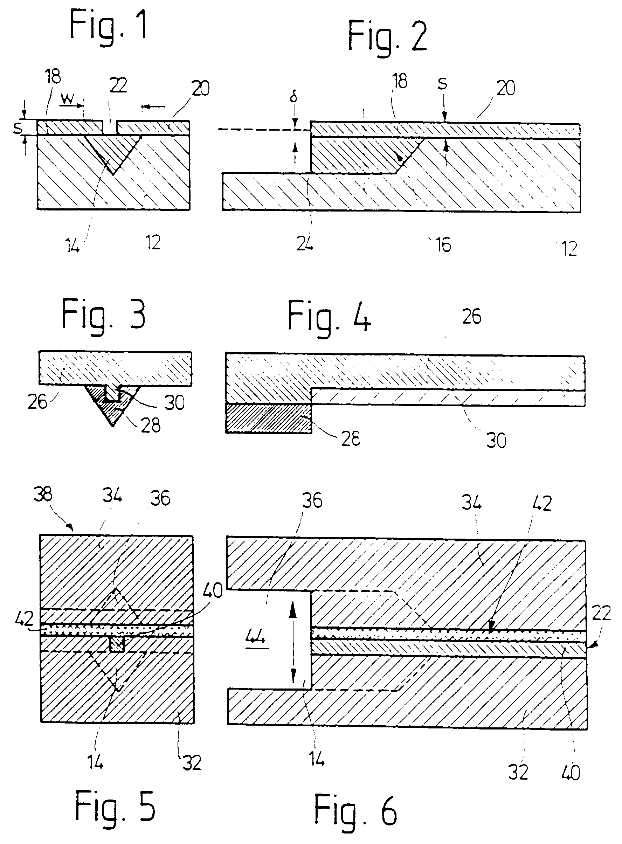

Die in den Figuren 1 und 2 dargestellte Masterstruktur soll beispielhaft die integrierte Faser-Chip-Kopplung eines polymeren Bauelements 10 verdeutlichen. Tatsächlich sind auf jedem polymeren Bauelement eine Vielzahl von Faser-Chip-Kopplungen angeordnet. Die Faser-Chip-Kopplung ist jedoch wesentliche Voraussetzung für die später beschriebene eigentliche vertikale Koppelstruktur.

Die Masterstruktur - hier substratplattenseitig dargestellt - besteht aus einem Siliciumsubstrat 12, in das zur Aufnahme einer hier nicht dargestellten Glasfaser eine Faserführungsstruktur 14 (Positioniergraben) mit V-förmigem Querschnitt anisotrop eingeätzt wird.

Durch die an sich bekannten anisotropen Ätztechniken des Siliciums können V-förmige Grabenstrukturen in den {100} orientierten Wafer geätzt werden, wobei sich die Tiefe dieser Gräben abhängig von der Weite einer rechteckförmigen Öffnung w in der Ätzmaske parallel zur <110>-Richtung einstellt. Die sich ausbildenden geneigten {111}-Seitenflächen bilden dabei einen durch die anisotropen Ätzeigenschaften des Kristalls definierten, natürlichen Ätzstop. Eine solche V-Nut ist als Faserführungsstruktur 14 besonders geeignet, da die Winkeljustage (parallel zur Kristalloberfläche) sich automatisch einstellt und über die Öffnungsweite der V-Nut sich die Höhenlage δ des Faserkerns über der Waferoberfläche exakt einstellen und fertigungstechnisch kontrollieren läßt.

Für die spätere Höhenlage des Faserkerns gilt folgende Beziehung:

$$\delta = \frac{R}{2\cos\alpha} - \frac{w}{2}\tan\alpha$$

mit R = Fasermanteldurchmesser (typ. 125 μm), α = Neigungswinkel der {111}-Flächen gegen die Waferoberfläche (α = 54.7356°), w = Weite der V-Nut an der Waferoberfläche. Eine Änderung von Δ w = 1 μm resultiert in einer Änderung der Höhenlage Δδ = 0.7 μm.

Nach Ätzen der V-Nuten in Silicium werden diese mit polymeren Materialien 16 planarisiert (eben aufgefüllt), so daß eine ebene Oberfläche 18 für die anschließende Beschichtung mit Photolack oder einem anderen strukturierbaren Polymer 20 entsteht. In diese Deckschicht 20 der Dicke s werden grabenförmige Öffnungen 22 mit typischen Abmessungen von 6 μm x 6 μm Querschnittsfläche (= Strukturbreite x Schichtdicke s) strukturiert, welche die Abmessungen der späteren Lichtwellenleiter definieren (die Höhenlage des Faserkerns über der Waferoberfläche müßte in diesem Beispiel δ = 3 μm betragen, damit die optischen Achsen von Lichtwellenleiter und Glasfaser miteinander fluchten).

Anschließend werden die Faserführungsstrukturen 14, vorzugsweise mittels Excimer-Laserablationstechnik, teilweise wieder geöffnet und dabei ein senkrechter Faseranschlag 24 am lichtwellenleiterseitigen Ende der V-Nut geschnitten. Diese Technik ermöglicht eine Führung der Lichtwellenleiter in den Öffnungen 22 über die schrägen Endflächen der V-Nuten hinaus zu einem senkrecht geschnittenen Anschlag, so daß Lichtleitfaser (Glasfaser) und Lichtwellenleiter direkt auf Stoß miteinander gekoppelt werden können.

Die laterale Justage der an die Fasern anschließenden Lichtwellenleiter kann durch übliche Techniken der Photolithographie mit ausreichender Präzision erreicht werden.

Gemäß der Figuren 3 und 4 wird diese Masterstruktur aus Lichtwellenleiter-Vorstrukturen (Öffnung 22) und integrierten Faserführungsstrukturen 14 auf Silicium durch gängige Galvanikverfahren abgeformt, so daß eine Negativform 26, beispielsweise aus Nickel, entsteht. Die Negativform 26 besitzt einen Bereich 28, der die Faserführungsstruktur 14 und einen Bereich 30, der die Öffnung 22 nachbildet. Durch Spritzguß- oder Spritzprägeverfahren können mit dieser Negativform 26 zahlreiche Tochterkopien der Masterstruktur in Polymermaterial (z.B. PMMA oder Polycarbonat) hergestellt werden.

Im Beispiel ist, wie bereits erwähnt, nur eine Faserführungsstruktur 14 einer polymeren Substratplatte näher erläutert worden. Das fertige polymere Bauelement 10 besitzt jedoch eine Vielzahl von Faserführungsstrukturen 14 und später die Lichtwellenleiter ergebenden Öffnungen 22. Weiterhin besitzt das Bauelement 10 eine polymere Deckelplatte 34, in der ebenfalls Faserführungsstrukturen 14 und Öffnungen 22 angeordnet sind. Ebenfalls besitzen sowohl die polymere Substratplatte 32 als auch die polymere Deckelplatte 34 Justagestrukturen 36. Die Justagestrukturen 36 sind nach der Montage genau einer Faserführungsstruktur 14 gegenüberliegend angeordnet.

Die Justagestrukturen 36 werden auf die gleiche, bereits beschriebene Weise wie die Faserführungsstrukturen 14, vorzugsweise V-förmig, anisotrop eingeätzt.

Es wird jeweils eine komplette Masterstruktur für eine polymere Substratplatte 32 und eine polymere Deckelplatte 34 angefertigt. Das Layout, also die Lage von Faserführungsstrukturen 14, Justagestrukturen 36 und Öffnungen 22 richtet sich nach dem späteren Aufbau des kompletten polymeren Bauelements 10.

In den Figuren 5 und 6 ist eine Faser-Chip-Koppelstelle 38 eines fertigen polymeren Bauelements 10 komplett gezeigt.

Die Koppelstelle 38 besteht aus einer, in der Substratplatte 32 angeordneten Faserführungsstruktur 14 sowie einem, in die Öffnungen 22 eingefüllten Lichtwellenleiter 40. Der Faserführungsstruktur 14 ist in der Deckelplatte 34 eine Justagestruktur 36 zugeordnet. Zwischen Deckelplatte 34 und Substratplatte 32 ist eine optische Pufferfolie 42 vorgesehen. In der, sich bei aufgelegter Deckelplatte 34 ergebenden Aussparung 44 liegt, hier nicht dargestellt, die Glasfaser und fluchtet mit ihrer optischen Achse, dadurch, daß die Faserführungsstruktur 14 tiefer ausgebildet ist als die Justagestruktur 36, mit der optischen Achse des in der Substratplatte 32 angeordneten Lichtwellenleiters 40. Auf Einzelheiten der Tiefenausbildung der Strukturen 14 und 36 und der Stärke der Pufferfolie 42 wird weiter unten eingegangen.

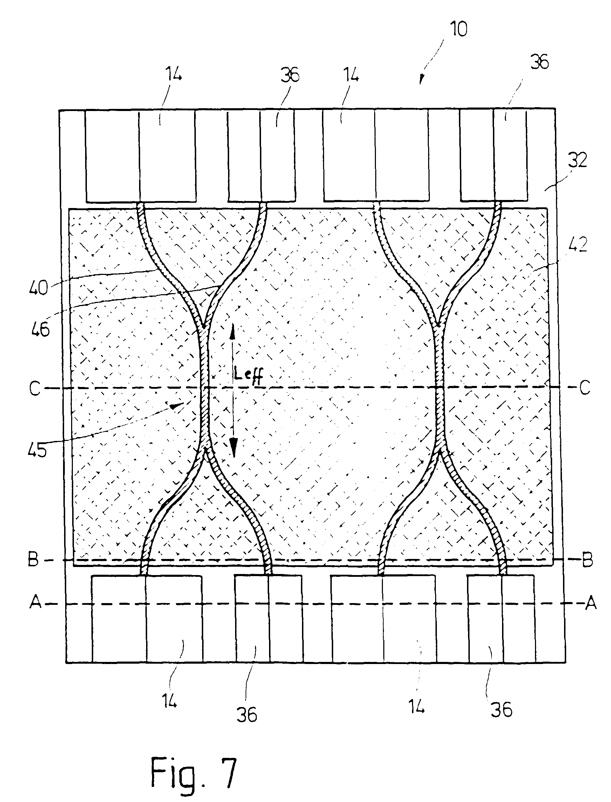

In Figur 7 ist ein als 2x2 Richtkoppler ausgebildetes polymeres Bauelement 10 in einer Projektionsdraufsicht gezeigt.

Polymere Substratplatte 32 und Deckelplatte 34 (hier nicht dargestellt) weisen für sich Faserführungsstrukturen 14 (V-Nuten) Justagestrukturen 36 und Wellenleiter-Vorstrukturen (Öffnungen 22) auf, so daß bei der übereinanderliegenden Montage vertikale Koppelstrukturen 45 entstehen, die in übereinanderliegenden Bereichen der Lichtwellenleiter 40, 46 nur noch über die Dicke einer dazwischengelegten Polymerfolie (Pufferfolie 42) geeigneter optischer Eigenschaften getrennt sind.

In der Figur 7 liegen die Lichtwellenleiter 40 in der polymeren Substratplatte 32 (unten). Die zugehörigen Faserführungsstrukturen 14 (V-Gräben) sind in der Aufsicht etwas breiter, damit die (damit tieferliegenden) Glasfaserachsen fluchtend mit den optischen Achsen der zugehörigen Lichtwellenleiter 40 zu liegen kommen. Die Pufferfolie 42 kommt über die Lichtwellenleiter 40 der Substratplatte 32 zu liegen. Die Lichtwellenleiter 46 (die eigentlich an der Unterseite der polymeren Deckelplatte 34 liegen) kommen dann in einem montierten Bauelement 10, wie beispielhaft gezeichnet, in Position. Die schmäleren V-Gräben in der Substratplatte 32 bilden die Justagestrukturen 36 der in der Deckelplatte 34 in den Faserführungsstrukturen 14 zu halternden Glasfasern und dienen damit gleichzeitig einer Justage von Deckelplatte 34 und Substratplatte 32 zueinander. Der Koppelabstand (Foliendicke der Pufferfolie 42) und die effektive Koppellänge $L_{eff}$ (abhängig vom detaillierten Layout eines Kopplers) eines solchen passiven Richtkopplers bestimmen, ob beispielsweise das Licht aus dem untenliegenden Lichtwellenleiter 40 vollständig in den obenliegenden Lichtwellenleiter 46 überkoppelt, oder in einem festgelegten Verhältnis zwischen beiden Lichtwellenleitern 40, 46 aufgeteilt wird.

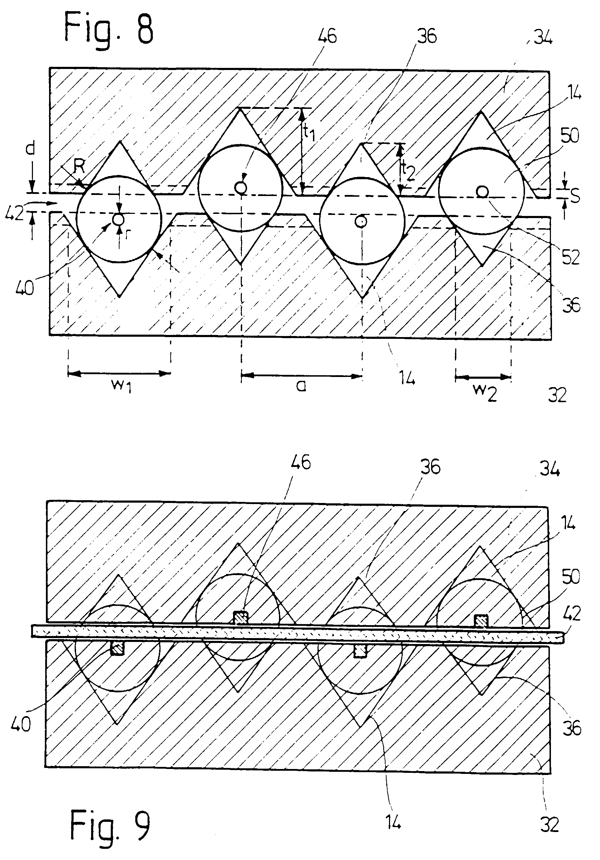

Der genaue Aufbau des Bauelements 10 wird anhand der in den Figuren 8 bis 10 gezeigten Querschnitte der Linien A - A, B - B, C - C erklärt.

Figur 8 zeigt einen Schnitt durch den Bereich der Faserführungsstrukturen 14 und der Justagestrukturen 36 mit eingelegten Glasfasern 50.

Typische Werte für Glasfasern 50 betragen R = 125 µm für den Fasermanteldurchmesser und r = 9 µm für den Felddurchmesser eines Glasfaserkerns 52. Die Glasfasern 50 sind lateral in einem Rastermaß a (typisch 250 µm) angeordnet, wobei die Glasfasern 50 paßgenau zu den optische Achsen der durch sie jeweils zu kontaktierenden Lichtwellenleiter 40, 46 in Substratplatte 32 bzw. Deckelplatte 34 liegen. Dies setzt bei einer angenommenen Tiefe s der Lichtwellenleiter 40, 46 einen vertikalen Versatz um d + 2(s/2) = d + s voraus (d ist der durch die Dicke der Pufferfolie 42 bestimmte Abstand zwischen Substratplatte 32 und Deckelplatte 34). Die Tiefen der polymeren Führungsstrukturen $t_1$ und $t_2$ (Faserführungsstruktur 14 bzw. Justagestruktur 36) ergeben sich hier aus der Tiefe der jeweiligen in Silicium geätzten V-Nut plus der Dicke s der polymeren Deckschicht (Photolack) auf der Masterstruktur, in welche die Öffnungen 22 strukturiert wurden (entspricht der Tiefe der Lichtwellenleiter 40, 46). Nachdem die Masterstruktur galvanisch abgeformt und spritzgegossen wurde, ist in den Polymerstrukturen der Figur 7 natürlich eine Unterscheidung zwischen ursprünglicher Si-Oberfläche 18 und Polymerdeckschicht 20 nicht mehr möglich - zur Verdeutlichung wurde deswegen hierfür jeweils eine gestrichelte waagerechte Hilfslinie eingezeichnet.

Die Weiten der in die Silicium-Masterstrukturen zu ätzenden V-Nuten $w_1$ für die Faserführungsstrukturen 14 und $w_2$ für die jeweiligen V-förmige Justagestrukturen 36 auf der gegenüberliegenden Polymerplatte sind in diesem Beispiel leicht zu berechnen:

$$w_i = \frac{R}{\sin\alpha} - \frac{2\delta_i}{\tan\alpha}$$

Im genannten Beispiel folgt $w_1$ = 148.8 µm (für $\delta_1$ = 3 µm) und $w_2$ = 126.2 µm (für $\delta_2$ = d + 3/2 s = 19 µm).

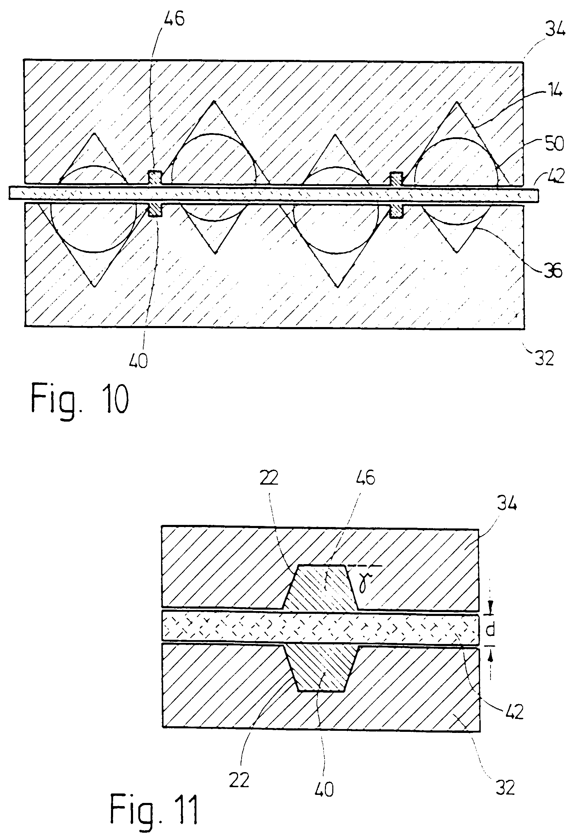

In den Figuren 9 und 10 sind Querschnitte durch das Richtkoppelbauelement 10 der Figur 7 gezeichnet, wobei die Figur 9 den Schnitt (B - B) kurz hinter der Faserkoppelstelle zeigt und die jeweils mit ihren optischen Achsen fluchtende Stoßkopplung der Glasfasern an die abwechselnd in Substrat- bzw. Deckelplatte liegenden Lichtwellenleiter verdeutlicht.

In Figur 10 ist der Schnitt (C - C) durch die Mitte des Koppelbereichs 45 gelegt, in dem die Lichtwellenleiter 40, 46 genau übereinander zu liegen kommen und der Koppelabstand nur über die Dicke d der Pufferfolie 42 bestimmt ist. Wichtig ist hier die genaue Justage der Lichtwellenleiter 40, 46 zueinander, welche durch die V-förmigen Führungen (Faserführungsstruktur 14 und Justagestruktur 36) in Deckelplatte 34 und Substratplatte 32 und die darin eingelegten Glasfasen 50 erfolgt, da die V-förmigen Strukturen jeweils zwei definierte Auflagepunkte an den runden Glasfasern 50 einnehmen können (spielfrei). Die Führungen sind durch die photolithographische Herstellung lateral mit Submikrometergenauigkeit hinreichend genau positionierbar. Bei der Montage der Bauelemente 10 werden die Glasfasern 50 in ihre Faserführungsstruktur 14 eingelegt und dann vernetzbare Präpolymere (core-Polymer) in die Lichtleitergräben (Öffnungen 22) der Substratplatte 32, die somit die Lichtwellenleiter 40 ergeben, eingefüllt, die Pufferfolie 42 aufgelegt und die ebenfalls mit Präpolymer aufgefüllte Deckelplatte 34 von oben aufgedrückt. Überstehendes Präpolymer wird durch diese Montagetechnik weggedrückt und sorgt nach seiner Vernetzung für eine flächige Verbindung. In Abhängigkeit von der Viskosität des Präpolymers muß eventuell eine dünne, flächige Restschichtdicke desselben bei der Festlegung der Foliendicke der Pufferfolie mit eingerechnet werden.

Eine einfache Abschätzung zeigt, daß der Koppelabstand k (gerechnet zwischen Lichtwellenleitermitten) variiert mit $\Delta k^2 = (d + s)^2 + \Delta y^2$.

Mit den Daten aus dem obigen Beispiel ergeben sich aus einer lateralen Fehljustierung der Lichtwellenleiter von $\Delta y = 4 \mu m$ (und unter Annahme radialsymmetrischer optische Felder) Änderungen des Koppelabstandes $\Delta k \approx 0.5 \mu m$.

Zur vereinfachten Montage muß die Polymerfolie 42 nicht unbedingt paßgenau bis an die Lichtwellenleiterenden der Lichtwellenleiter 40, 46 geführt werden. Wegen der sehr geringen Indexunterschiede von Wellenleitercore und Substrat/Folie sind die Austrittsaperturwinkel an den Lichtwellenleiterenden sehr klein (ähnlich denjenigen der Monomodefasern). Da das Präpolymer wie eine Indexflüssigkeit die Felder bis an die Glasfaserendfläche führt, kann der eigentliche Lichtwellenleiter 40, 46 schon in Abständen von etwa 20-50 μm vor dem Glasfaserende bei tolerierbar kleinen Koppelverlusten enden. Damit sind Toleranzen der Folienabmessungen in Lichtwellenleiterrichtung in dieser Größenordnung zulässig.

In Figur 11 ist ein Koppelbereich 45 im Schnitt näher gezeigt.

Die Querschnittsabmessungen der Lichtwellenleiter-Grabenstrukturen (Öffnungen 22) sind so zu dimensionieren, daß abhängig von der zu führenden Lichtwellenlänge einerseits monomodige Lichtführung möglich ist und andererseits die radialsymmetrische Feldverteilung der Glasfaser 50 möglichst gut angenähert wird, um hohe Koppelwirkungsgrade zu erzielen. Dazu muß der Brechungsindex des lichtführenden Polymers (Wellenleitercore) in den Öffnungen 22 geringfügig höher liegen als die Brechungsindices von Substratplatte 32, Deckelplatte 34 und Pufferfolie 42. Typische Querschnittsabmessungen für Monomode-Bauelemente bein $\lambda = 1300$ nm betragen 6 μm x 6 μm bei einem Indexunterschied $n_{core} - n_{Substrat}$ 0,003. Entsprechend der Figur 11 können die Flanken der Lichtwellenleiter 40, 46 vorteilhaft um einen Winkel $70° \leq \alpha \leq 90°$ geneigt sein, um eine leichtere Entformung beim Spritzguß zu ermöglichen (trapezförmiger Querschnitt). Die optimale Dicke für eine optische Pufferfolie 42 ist stark von deren Brechungsindex abhängig. Für einen angenommenen Brechungsindex, ähnlich dem des Substrates im obigen Beispiel, könnte die Dicke dann beispielsweise 10 μm betragen (die optimale Auslegung der Richtkopplerstrukturen muß im Einzelfall an die Feldverteilungen und Koppelabstände angepaßt werden).

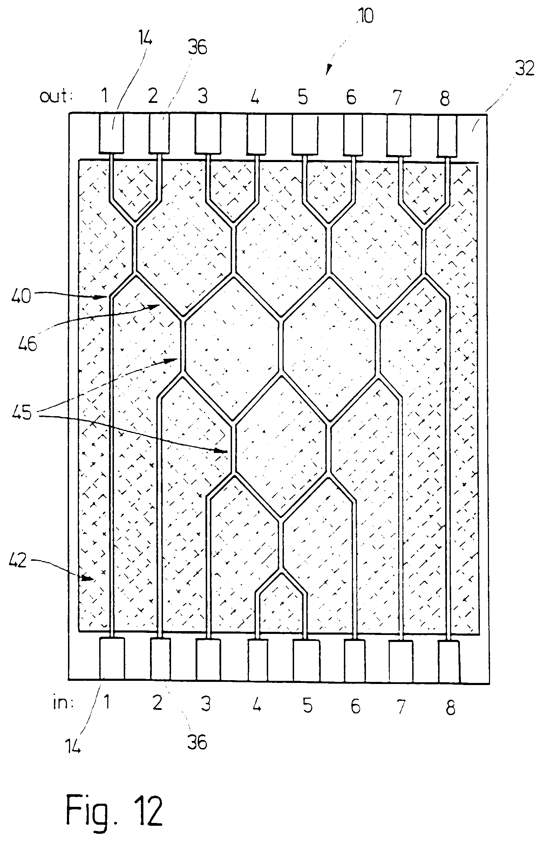

In Figur 12 ist in Projektionsdraufsicht am Beispiel eines 1 x 8 Leistungsteilers ein weiteres polymeres Bauelement 10 gezeigt. Das Bauelement besitzt Eingänge 1 bis 8 und Ausgänge 1 bis 8, die jeweils durch Lichtwellenleiter 40, 46 miteinander verbunden sind.

Wie in Figur 7 ist eine Aufsicht auf die Substratplatte 32 mit ihren Lichtwellenleitern 40 und Faserführungsstrukturen 14 dargestellt. Darüberliegend ist die Pufferfolie 42 und die gedachte Lage der in der Deckelplatte 34 liegenden Lichtwellenleiter 46 eingezeichnet. Ferner sind zur vereinfachten Darstellung die einzelnen S-förmigen Lichtwellenleiterbiegungen an den Ein- und Ausgängen eines jeden Koppelbereiches 45 nur schematisch, jeweils durch eine schräge Verbindung, repräsentiert. Es ist gezeigt, wie beispielsweise abwechselnde Lichtwellenleiter 40, 46 aus der oberen und der unteren Ebene (Substratplatte 32, Deckelplatte 34) miteinander gekoppelt werden können, um eine optische Signalaufteilung eines Eingangs (z.B. Eingang Nr. 5) auf die Ausgänge 1 bis 8 zu erreichen. Im gezeichneten Beispiel betrüge die Signalleistung (bei Vernachlässigung von Verlusten) 1/16 der Eingangsleistung an den Ausgängen 1, 2, 7, 8 und 3/16 der Eingangsleistung an den Ausgängen 3, 4, 5, 6.

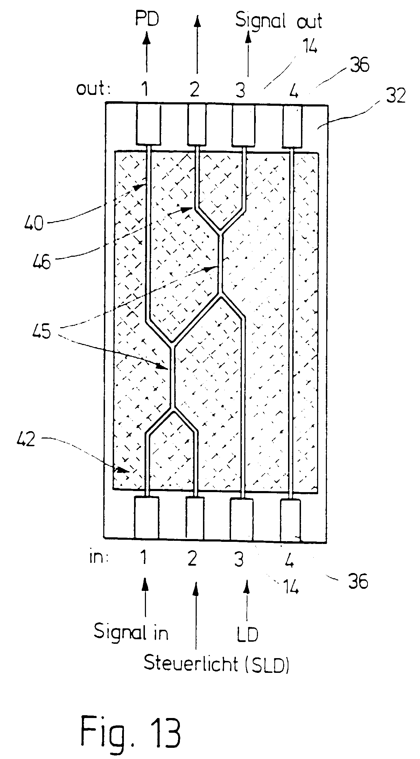

In Figur 13 ist ein weiteres Ausführungsbeispiel, das einen optisch-gesteuerten optischen Schalter zeigt, dargestellt. Beispielhaft wird hier die Schaltfunktion anhand eines optischen Bypass-Schalters beschrieben, sinngemäße Erweiterungen des Schaltprinzips bis hin zu Schaltmatrizen für Vermittlungsfunktionen sind möglich.

Zur prinzipiellen Herstellung und zum Aufbau wird auf die bereits zu den anderen Beispielen gemachten Erläuterungen verwiesen.

Im Normalzustand wird das einfallende Signallicht von Eingang 1 auf die Photodiode (PD) am Ausgang 1 geführt und das Licht eines lokalen Sendelasers (LD) über den Eingang 3 auf den Ausgang 3 geleitet (Eingang 4 ist unbelegt). Dazu wird auf beiden Lichtpfaden jeweils ein Richtkoppler 45 im "bar"-Zustand durchlaufen, d.h. das Licht koppelt aus dem unteren Lichtwellenleiter 40 nicht in den oberen Lichtwellenleiter 46 über. Dies wird durch eine gezielte Verstimmung ($\Delta\beta$) der Ausbreitungskonstanten ($\beta$) im oberen Lichtwellenleiter 46 mit einer optisch-induzierten Brechungsindexänderung im oberen Lichtwellenleiter 46 erreicht: Hierfür kann dieser beispielsweise ein nichtlinear-optisches $\chi^{(3)}$-Polymer enthalten, welches durch ein zusätzlich eingestrahltes Steuerlichtsignal seinen Brechungsindex geringfügig absenkt. Wird das Steuerlichtsignal ausgeschaltet, verschwindet die Indexabsenkung und die Richtkoppler 45 werden jeweils in den "cross"-Zustand umgeschaltet, d.h. das Eingangssignallicht geht auf den Ausgang 3 und das Licht des Sendelasers in den unbelegten Ausgang 2 (Senke). Diese Schaltfunktion wäre beispielsweise sinnvoll bei Störung (Spannungsausfall) einer Teilnehmerstation, bei der dann diese Station solange überbrückt würde, bis der Steuerlichtstrahl wieder eingeschaltet wird. Das Steuerlicht kann lokal in der Empfangsstation erzeugt werden (beispielsweise durch eine direkt an den optischen Polymerchip angekoppelte SLD) oder über eine Faser über das lokale Netz herangeführt werden (optischer "remote"-Schalter).

Während normalerweise die $\chi^{(3)}$-Nichtlinearitäten sehr klein sind und unakzeptabel hohe Steuerlichtleistungen erfordern würden, liefern sogenannte cis/trans-Nichtlinearitäten (Molekülstrukturänderungen) ausreichend starke Brechungsindexänderungen von $\Delta n \approx$ 0.0008 schon bei Lichtleistungen von wenigen $\approx$ m Watt, allerdings in der Regel auf Kosten der Schaltgeschwindigkeiten. Beispielsweise können "Methylrot-Derivate" in Präpolymeren (z.B. optische Epoxiden) gelöst werden und so in die Lichtleitergräben (Öffnungen 22) als core-material eingefüllt und vernetzt werden. Geschaltet wird hier mit "rotem" Licht im Wellenlängenbereich 600-700 nm. Für die Steuerlichtquelle kann (anders als für die teuren Sendelaser bei 1300 nm bzw. 1550 nm) eine billige, breitbandige rote Laserdiode oder sogar eine einfache Superlumineszensdiode (SLD) verwendet werden, wenn nur genügend Lichtleistung (einige mW) in den Lichtwellenleiter 46 eingekoppelt werden kann. Da die Lichtwellenleiter 46 beispielsweise für 1550 nm monomodig dimensioniert sind, sind die selben Lichtwellenleiter 46 für 600-700 nm Wellenlänge mehrmodig, was die Lichteinkopplung aus der Steuerlichtquelle wesentlich vereinfacht. Zugleich klingen die evaneszenten Felder der kürzeren Wellenlänge erheblich schneller über die Dicke der Pufferfolie 42 ab, so daß praktisch kein Steuerlicht in die untenliegenden Nachrichtenkanäle (Lichtwellenleiter 40) überkoppelt, während das langwellige Licht den Koppler je nach Schaltzustand im cross- oder im bar-Zustand durchlaufen kann.

Die genannten Schaltfunktionen sind je nach Auslegung der Richtkoppler 45 und die gewünschte Systemanwendung sinngemäß auch so anzuwenden, daß ein Umschalten der Richtkoppler 45 von cross nach bar (oder umgekehrt) durch Einschalten der Steuerlichtquelle erfolgt - die zugehörigen Schaltgeschwindigkeiten bekannter $\chi^{(3)}$-Materialien sind beim Einschaltvorgang höher.

## Patentansprüche

1. Verfahren zur Herstellung eines optischen Koppelelements mit Bereichen zur Aufnahme der zu verkoppelnden Lichtleitfasern, mit Lichtwellenleitern, sowie mit mindestens einer integrierten vertikalen Koppelstruktur, bei dem

    a.) eine polymere Substratplatte (32) mit wenigstens einem Paar Justagestrukturen (36), einem Paar Faserführungsstrukturen (14), sowie einer Öffnung (22) zur Aufnahme eines ersten Wellenleiters (40), die die beiden Faserführungsstrukturen (14) miteinander verbindet, hergestellt wird, bei dem

    b.) eine polymere Deckelplatte (34) mit wenigstens einem Paar Justagestrukturen (36), einem Paar Faserführungsstrukturen (14), sowie einer Öffnung (22) zur Aufnahme eines zweiten Wellenleiters (46), die die beiden Faserführungsstrukturen (14) miteinander verbindet, hergestellt wird, wobei die Strukturen (36,14,22) in den beiden polymeren Platten (32,34) so angeordnet werden, daß bei einem Zusammenfügen der beiden polymeren Platten jeweils eine Justagestruktur (36) und eine Faserführungsstruktur (14) eine Aussparung (44) mit durchgehend rautenförmigem Querschnitt zur Aufnahme von Lichtleitfasern bilden, daß jeweils einer der Wellenleiter (40, 46) den Mittelpunkt der Raute umfaßt, und daß der erste Wellenleiter (40) und der zweite Wellenleiter (46) wenigstens in einem Bereich (45) parallel laufen, und eine intergriert vertikale Koppelstruktur bilden, bei dem

    c.) die Öffnungen (22) in der polymeren Substratplatte (32) und in der polymeren Deckelplatte (34) mit einem Präpolymer aufgefüllt werden, so daß Lichtwellenleiter gebildet werden, und bei dem

    d.) die beiden polymeren Platten (32,34) zusammengefügt werden.

2. Verfahren nach Anspruch 1, bei dem der rautenförmige Querschnitt der Aussparung (44) so ausgebildet wird, daß die aufzunehmende Lichtleitfaser den Querschnitt an vier Punkten berührt, bei dem vor dem Zusammenfügen der beiden polymeren Platten (32,34) die aufzunehmende Lichtleitfaser in die Strukturen (36,14) der polymeren Substratplatte (32) eingelegt werden, und bei dem die polymere Deckelplatte (32) beim Auflegen auf die polymere Substratplatte (32) durch die in die Strukturen (36,14) der polymeren Deckelplatte (32) hineinragende Lichtleitfaser geführt wird.

3. Verfahren nach einem der vorhergehenden Ansprüche, bei dem eine Pufferfolie (42) zwischen die polymere Substratplatte (32) und die polymere Deckelplatte (34) eingebracht wird, bevor die beiden polymeren Platten (32,34) zusammengefügt werden.

4. Verfahren nach Anspruch 3, bei dem der vertikale Koppelabstand der parallel geführten Lichtwellenleiter (40, 46) durch die zwischen Substratplatte (32) und Deckelplatte (36) eingelegte optische Pufferfolie (42) bestimmt wird.

5. Verfahren nach einem der Ansprüche 3 oder 4, bei dem der Koppelgrad zwischen den in der Substratplatte (32) und in der Deckelplatte (36) angeordneten Lichtwellenleitern (40, 46) durch die Länge des parallel geführten Bereiches (45) und die optische Dicke der Pufferfolie (42) eingestellt wird.

6. Verfahren nach einem der Ansprüche 3 oder 4, bei dem der Koppelgrad über die Brechungsindices des die Lichtwellenleiter (40, 46) ergebenden lichtführenden Polymers, der Substratplatte (32), der Deckelplatte (34) und der Pufferfolie (42) eingestellt wird.

7. Verfahren nach einem der vorhergehenden Ansprüche, bei dem auf der substratplatte (32) und/oder der Deckelplatte (34) eine Vielzahl von Faserführungsstrukturen (14) und Justagestrukturen (36) sowie die Faserführungsstrukturen (14) verbindenden, später die Lichtwellenleiter (40, 46) bildenden grabenförmigen Öffnungen (22) vorgesehen werden, wobei die Öffnungen 822) der Substratplatte (32) jeweils wenigstens einen Bereich aufweisen, in dem sie nach der Montage mit wenigstens einem Bereich wenigstens einer Öffnung (22) der Deckelplatte (34) vertikal beabstandet parallel verlaufen und/oder die Öffnungen (22) der Deckelplatte (34) jeweils wenigstens einen Bereich aufweisen, in dem sie nach der Montage mit wenigstens einem Bereich wenigstens einer Öffnung (22) der Substratplatte (32) vertikal beabstandet parallel verlaufen.

8. Verfahren nach einem der vorhergehenden Ansprüche, bei dem in die Öffnungen (22) der Substratplatte (32) und der Deckelplatte (34) unterschiedliche lichtführende Polymere mit unterschiedlichen thermooptischen, nichtlinearoptischen oder akustooptischen Eigenschaften eingefüllt werden.

9. Verfahren nach einem der vorhergehenden Ansprüche, bei dem zwischen Substratplatte (32) und Deckelplatte (34) eine nach außen geführte, Elektroden aufweisende Pufferfolie (42) eingelegt wird und die Elektroden im Bereich neben wenigstens einer vertikalen Koppelstelle (45) liegen.

10. Verfahren nach Anspruch 9, bei dem die Electroden aufweisende Pufferfolie (42)so ausgebildet ist, daß über die Elektroden Schaltfunktionen, beispielsweise durch thermooptische Effekte oder durch akustische Wellen, angeregt in piezoelektrischem Folienmaterial über Interdigitalelektroden, auf die im Koppelbereich (45) liegenden Lichtwellenleiter (40, 46) ausgeführt werden können.

11. Verfahren nach einem der vorhergehenden Ansprüche, bei dem auf jeweils einem Siliciumsubstrat (12) eine Masterstruktur für die Substratplatte (32) und für die Deckelplatte (34) zur Aufnahme der Lichtwellenleiter (40) als auch die Faserführungsstrukturen (14) sowie die Justagestrukturen (36) hergestellt werden, diese Masterstrukturen galvanisch abgeformt werden und die Negativform (26) zur Herstellung von, mit der Masterstruktur identischen Tochterstrukturen, beispielsweise im Spritzguß- oder Spritzprägeverfahren in polymeren Kunststoffen eingesetzt werden.

12. Verfahren nach Anspruch 11, bei dem die Faserführungsstruktur (14) und die Justagestruktur (36) an sich bekannt anisotrop in ein Siliciumsubstrat oder einen anderen Kristall eingeätzt werden, diese eingeätzten V-förmigen Strukturen mit polymeren Materialien (16) aufgefüllt werden, so daß sich eine ebene Oberfläche (18) mit einem Photolack oder einem anderen stukturierbaren Polymer (20) beschichtet werden, in die polymere Beschichtung (20) grabenförmige, später die Lichtwellenleiter (40) ergebende, Öffnungen (22) strukturiert werden und die Faserführungsstrukturen (14) und die Justagestrukturen vorzugsweise mittels Laserablation geöffnet werden.

13. Verfahren nach der Ansprüche 11 oder 12, bei dem die Faserführungsstrukturen (14) und die Justagestrukturen (36) so geöffnet werden, daß senkrechte zur axialen Richtung der Strukturen verlaufende, einen Anschlag bildende Flächen (24) am späteren lichtwellenleiterseitigen Ende der Strukturen entstehen.

14. Verfahren nach einem der Ansprüche 11 bis 13, bei dem die grabenförmigen, später die Lichtwellenleiter (40) ergebenden Öffnungen (22), so strukturiert werden, daß sie jeweils zwei sich in der Substratplatte (32) oder Deckelplatte (34) gegenüberliegende Faserführungsstrukturen (14) verbinden, wobei sie wenigstens einen Bereich (45) aufweisen, in dem die Öffnung für die substratplattenseitigen Lichtwellenleiter (40) nach der Montage vertikal beabstandet parallel zu der Öffnung für den deckelplattenseitigen Lichtwellenleiter (46) verläuft.

15. Verfahren nach einem der Ansprüche 11 bis 14, bei dem die Faserführungsstrukturen (14) soweit in die Substratplatte (32) und Deckelplatte (34) eingeätzt werden, daß die optischen Achsen eingelegter Lichtleitfasern (50) mit den optische Achsen der in den Öffnungen eingefüllten Lichtwellenleiter (40, 46)fluchten.

16. Verfahren nach einer Ansprüche 11 bis 15, bei dem die Justagestrukturen (36) um den Betrag flacher eingeätzt werden, um den die Faserführungsstrukturen (14) tiefer eingeätzt werden.

17. Optisches Koppelelement mit einer polymeren Substratplatte (32), in der wenigstens ein Paar Justagestrukturen (36), ein Paar Führungsstrukturen (14) zur Aufnahme von zu verkoppelnden Fasern, sowie ein erster Wellenleiter (40) gebildet sind, wobei der Wellenleiter (40) die beiden Führungsstrukturen (14) miteinander verbindet, mit einer polymeren Deckelplatte (34), in der wenigstens ein Paar Justagestrukturen (36), ein Paar Führungsstrukturen (14) zur Aufnahme von zu verkoppelnden Fasern sowie ein zweiter Wellenleiter (46) gebildet sind, wobei der Wellenleiter (46) die beiden Führungsstrukturen (14) miteinander verbindet, wobei die beiden polymeren Platten (32,34) dergestalt zusammengefügt sind, daß jeweils eine Justagestruktur (36) und eine Führungsstruktur (14) eine Aussparung (44) mit durchgehend rautenförmigem Querschnitt zur Aufnahme von Lichtleitfasern bilden, daß jeweils einer der Wellenleiter (40,46) den Mittelpunkt der Raute umfaßt, und daß der erste Wellenleiter (40) und der zweite Wellenleiter (46) wenigstens in einem Bereich (45) parallel angeordnet sind und eine integriert vertikale Koppelstruktur bilden.

18. Optisches Koppelement nach Anspruch 17, bei dem zwischen der polymeren Substratplatte (32) und der polymeren Deckelplatte (34) eine Pufferfolie (42) vorgesehen ist, die die polymeren Platten (32,34) wenigstens im Bereich der Wellenleiter (40,46) wenigstens teilweise bedeckt.

19. Optisches Koppelement nach Anspruch 18, bei dem in der Pufferfolie (42) Elektroden, welche neben dem Bereich (45) der Wellenleiter liegen, vorgesehen sind.

**Claims**

1. Method for producing an optical coupling element having regions for receiving the optical fibres to be coupled, having optical waveguides and having at least one integrated vertical coupling structure, in which

a.) a polymer substrate plate (32) is produced which has at least one pair of adjusting structures (36), one pair of fibre-guiding structures (14) and one opening (22) for receiving a first waveguide (40), and which connects the two fibre-guiding structures (14) to one another, in which

b.) a polymer cover plate (34) is produced which has at least one pair of adjusting structures (36), one pair of fibre-guiding structures (14) and one opening (22) for receiving a second waveguide (46), and which connects the two fibre-guiding structures (14) to one another, the structures (36,14,22) being arranged in the two polymer plates (32,34) such that when the two polymer plates are joined an adjusting structure (36) and a fibre-guiding structure (14) in each case form a recess (44) with a continuously rhomboidal cross-section for receiving optical fibres, that in each case one of the waveguides (40, 46) includes the centre of the rhomboid, and that the first waveguide (40) and the second waveguide (46) run in parallel at least in one region (45) and form an integrated vertical coupling structure, in which

c.) the openings (22) in the polymer substrate plate (32) and in the polymer cover plate (34) are filled with a prepolymer, with the result that optical waveguides are formed, and in which

d.) the two polymer plates (32,34) are joined.

2. Method according to Claim 1, in which the rhomboidal cross-section of the recess (44) is designed such that the optical fibre to be received touches the cross-section at four points, in which before the two polymer plates (32,34) are joined the optical fibre to be received is inserted into the structures (36,14) of the polymer substrate plate (32), and in which when being mounted on the polymer substrate plate (32) the polymer cover plate (34) is guided by the optical fibre projecting into the structures (36,14) of the polymer cover plate (34).

3. Method according to one of the preceding claims, in which the buffer film (42) is introduced between the polymer substrate plate (32) and the polymer cover plate (34) before the two polymer plates (32,34) are joined.

4. Method according to Claim 3, in which the vertical coupling spacing between the optical waveguides (40, 46) guided in parallel is determined by the optical buffer film (42) inserted between the substrate plate (32) and cover plate (36).

5. Method according to one of Claims 3 or 4, in which the degree of coupling between the optical waveguides (40, 46) arranged in the substrate plate (32) and in the cover plate (36) is set by the length of the region (45) guided in parallel and the optical thickness of the buffer film (42).

6. Method according to one of Claims 3 or 4, in which the degree of coupling is set via the refractive indices of the light-guiding polymer, producing the optical waveguides (40, 46), the substrate plate (32), the cover plate (34) and the buffer film (42).

7. Method according to one of the preceding claims, in which there are provided on the substrate plate (32) and/or the cover plate (34) a multiplicity of fibre-guiding structures (14) and adjusting structures (36) as well as trench-shaped openings (22) which connect the fibre-guiding structures (14) and later form the optical waveguides (40, 46), the openings (22) in the substrate plate (32) in each case having at least one region in which, after assembly, they run, spaced apart vertically, in parallel with at least one region of at least one opening (22) in the cover plate (34), and/or the openings (22) in the cover plate (34) in each case have at least one region in which, after assembly, they extend, spaced apart vertically, in parallel with at least one region of at least one opening (22) in the substrate plate (32).

8. Method according to one of the preceding claims, in which different light-guiding polymers with different thermo-optical, optically non-linear or acousto-optical properties are filled into the openings (22) in the substrate plate (32) and the cover plate (34).

9. Method according to one of the preceding claims, in which a buffer film (42) which is guided to the outside and has electrodes is inserted between the substrate plate (32) and cover plate (34), and the electrodes are situated in the region next to at least one vertical coupling point (45).

10. Method according to Claim 9, in which the buffer film (42) having electrodes is designed such that the electrodes can execute switching functions, for example by means of thermo-optical effects or acoustic waves, excited in piezo-electric film material via interdigital electrodes, to the optical waveguides (40, 46) situated in the coupling region (45).

11. Method according to one of the preceding claims, in which there are produced on in each case one silicon substrate (12) a master structure for the substrate plate (32) and for the cover plate (34) for receiving the optical waveguides (40), as well as the fibre-guiding structures (14) and the adjusting structures (36), these master structures being moulded electrically, and the negative die (26) being used to produce, in polymer plastics, structures identical to the master structure using injection moulding or injection-compression moulding, for example.

12. Method according to Claim 11, in which the fibre-guiding structure (14) and the adjusting structure (36) are etched anisotropically in a manner known per se into a silicon substrate or another crystal, these etched V-shaped structures are filled with polymer material (16) so that a plane surface (18) is coated with a photoresist or another structurable polymer (20), trench-shaped openings (22) which later produce the optical waveguides (40) are structured in the polymer coating (20), and the fibre-guiding structures (14) and the adjusting structures are opened, preferably by means of a laser ablation.

13. Method according to Claim 11 or 12, in which the fibre-guiding structures (14) and the adjusting structures (36) are opened so as to produce at the end of the structures, which is later the optical fibre end, surfaces (24) which extend perpendicular to the axial direction of the structures and form a stop.

14. Method according to one of Claims 11 to 13, in which the trench-shaped openings (22) later producing the optical waveguides (40) are structured such that in each case they connect two fibre-guiding structures (14) opposite one another in the substrate plate (32) or cover plate (34), the said openings having at least one region (45) in which, after assembly, the opening for the optical waveguides (40) at the substrate-plate end extends, spaced apart vertically, in parallel with the opening for the optical waveguide (46) at the cover-plate end.

15. Method according to one of Claims 11 to 14, in which the fibre-guiding structures (14) are etched into the substrate plate (32) and cover plate (34) to the extent that the optical axes of inserted optical fibres (50) are aligned with the optical axes of the optical waveguides (40, 46) filled into the openings.

16. Method according to one of Claims 11 to 15, in which the adjusting structures (36) are etched less deeply by the amount by which the fibre-guiding structures (14) are etched deeper.

17. Optical coupling element having a polymer substrate plate (32) in which at least one pair of adjusting structures (36), one pair of guiding structures (14) for receiving fibres to be coupled, and a first waveguide (40) are formed, the waveguides (40) connecting the two guiding structures to one another, having a polymer cover plate (34) in which at least one pair of adjusting structures (36), one pair of guiding structures (14) for receiving fibres to be coupled, and a second waveguide (46) are formed, the waveguides (46) connecting the two guiding structures (14) to one another, the two polymer plates (32, 34) being joined in such a way that in each case an adjusting structure (36) and a guiding structure (14) form a recess (44) with a continuously rhomboidal cross-section for receiving optical fibres, that in each case one of the waveguides (40, 46) includes the centre of the rhomboid, and that the first waveguide (40) and the second waveguide (46) are arranged in parallel, at least in one region (45) and form an integrated vertical coupling structure.

18. Optical coupling element according to Claim 17, in which there is provided between the polymer substrate plate (32) and the polymer cover plate (34) a buffer film (42) which at least partially covers the polymer plates (32,34) at least in the region of the waveguides (40, 46).

19. Optical coupling element according to Claim 18, in which electrodes which are situated next to the region (45) of the waveguides are provided in the buffer film (42).

## Revendications

1. Procédé de fabrication d'un coupleur optique comportant des zones pour recevoir les fibres optiques à coupler, des guides de lumière ainsi qu'au moins une structure de couplage verticale, intégrée, selon lequel :

   a) on réalise une plaque substrat (32) en polymère avec au moins une paire de structures d'ajustage (36), une paire de structures de guidage de fibre (14) ainsi qu'une ouverture (22) pour recevoir un premier guide d'onde (40) reliant les deux structures de guidage de fibre (14), selon lequel,
   b) on réalise une plaque de couverture (34) en polymère ayant au moins une paire de structures d'ajustage (36), une paire de structures de guidage de fibre (14) ainsi qu'une ouverture (22) pour recevoir un second guide d'onde (46) reliant les deux structures de guidage de fibre (14), les structures (36, 14, 22) étant disposées dans les deux plaques en polymère (32, 34) pour qu'à la réunion des deux plaques en polymère, chaque fois une structure d'ajustage (36) et une structure de guidage de fibre (14) forment une cavité (44) ayant une section en losange, continue pour recevoir des fibres optiques, et que chaque fois l'un des guides d'onde (40, 46) entoure le centre du losange et que le premier guide d'onde (40) et le second guide d'onde (46) sont parallèles au moins dans une zone (45) et forment une structure de couplage verticale, intégrée, et,
   c) les ouvertures (22) dans la plaque substrat (32) en polymère et dans la plaque de couverture (34) en polymère sont remplies avec un pré-polymère pour former des guides de lumière et,
   d) on réunit les deux plaques en polymère (32, 34).

2. Procédé selon la revendication 1, selon lequel, la section en losange de la cavité (44) est réalisée pour que les guides de lumière à recevoir touchent la section en quatre points, et avant la réunion des deux plaques en polymère (32, 34), les fibres optiques à recevoir sont placées dans les structures (36, 14) de la plaque substrat (32) en polymère et on place la plaque de couverture (32) en polymère en l'appliquant sur la plaque substrat en polymère (32) pour guider les fibres optiques pénétrant dans les structures (36, 14) de la plaque de couverture (32) en polymère.

3. Procédé selon l'une des revendications précédentes, caractérisé en ce qu' on place une feuille tampon (42) entre la plaque substrat en polymère (32) et la plaque de couverture en polymère (34) avant de réunir les deux plaques en polymère (32, 34).

4. Procédé selon la revendication 3, dans lequel la distance de couplage verticale des guides de lumière (40, 46) parallèles est définie par la feuille tampon (42) optique placée entre la plaque substrat (32) et la plaque de couverture (36).

5. Procédé selon l'une des revendications 3 ou 4, selon lequel, le degré de couplage entre la feuille tampon (42) placée entre la plaque substrat (32) et les guides optiques (40, 46) placés dans la plaque substrat (32) et la plaque de couverture (36) est réglé par la longueur de la zone (45) en parallèle et par l'épaisseur optique de la plaque tampon (42).

6. Procédé selon l'une des revendications 3 ou 4, selon lequel, le degré de couplage est régulé par l'indice de réfraction du polymère conduisant la lumière dans les guides optiques (40, 46), la plaque substrat (32), la plaque de couverture (34) et la feuille tampon (42).

7.  Procédé selon l'une des revendications précédentes,
    selon lequel,
    la plaque substrat (32) et/ou la plaque de couverture (34) relient un grand nombre de structures de guidage de fibre (14) et de structures d'ajustage (36) ainsi que de structure de guidage de fibre (14), les ouvertures (22) en forme de sillons qui constitueront les futurs guides optiques (40, 46), les ouvertures (22) de la plaque substrat (32) ayant au moins une zone dans laquelle après montage avec au moins une ouverture (22) dans au moins une zone, la plaque de couverture (34) est parallèle à une distance verticale et/ou les ouvertures (22) de la plaque de couverture (34) comportent au moins une zone dans laquelle après le montage avec au moins une ouverture (22) dans au moins une zone de la plaque substrat (32), on a une disposition parallèle, écartée verticalement.

8.  Procédé selon l'une des revendications précédentes,
    selon lequel,
    dans les ouvertures (22) de la plaque substrat (32) et de la plaque de couverture (34), on introduit des polymères optiques, différents avec des propriétés thermo-optiques, d'optique non linéaire et d'acousto-optique, différentes.

9.  Procédé selon l'une des revendications précédentes,
    selon lequel,
    entre la plaque substrat (32) et la plaque de couverture (34) on place une feuille tampon (42) ayant des électrodes reliées à l'extérieur et ces électrodes se trouvent dans la zone à côté d'au moins un point de couplage vertical (45).

10. Procédé selon la revendication 1, selon lequel la feuille tampons (42) portant les électrodes est réalisée pour que les électrodes assurent des fonctions de commutation par exemple par effet thermo-optique ou par des ondes acoustiques par excitation dans la matière de la feuille piézo-électrique, par des électrodes internumériques sur le guide optique (40, 46) situé dans la zone de couplage (45).

11. Procédé selon l'une des revendications précédentes,
    selon lequel,
    chaque fois sur un substrat de silicium (12) on réalise une structure maître pour la plaque substrat (32) et pour la plaque de couverture (34) pour recevoir les guides optiques (40) ainsi que des structures de guidage de fibre (14) et des structures d'ajustage (36), ces structures maîtres étant formées par un procédé galvanique et le négatif (26) pour la fabrication étant utilisé pour des structures de copie, identiques à la structure maître, réalisées par exemple par injection ou par matriçage dans des polymères de synthèse.

12. Procédé selon la revendication 11,
    selon lequel,
    la structure de guidage de fibre (14) et la structure d'ajustage (36) sont gravées de manière anisotrope, connue, dans un substrat de silicium ou un autre cristal, et les structures à section en forme de V ainsi gravées sont remplies avec des polymères (16) et la surface supérieure plane (18) est enduite d'un photolaque ou d'un polymère (20) de structure différente et dans le revêtement en polymère (20) on réalise des ouvertures (22) en forme de sillons donnant ultérieurement les guides optiques (40) et les structures de réunion des fibres (14) et les structures d'ajustage étant de préférence ouvertes par ablation par laser.

13. Procédé selon les revendications 11 ou 12,
    selon lequel,
    les structures de guidage de fibre (14) et les structures d'ajustage (36) sont ouvertes pour former des surfaces (24) dirigées dans la direction axiale des structures et constituant une butée contre laquelle vient l'extrémité des futures structures du côté du guide optique.

14. Procédé selon l'une des revendications 11 à 13,
    selon lequel,
    les ouvertures (22) en forme de sillons qui formeront ultérieurement les guides optiques (40) sont structurées pour relier chaque fois deux structures de guidage de fibre (14) en regard, dans la plaque substrat (32) ou la plaque de couverture (34), et elles comportent au moins une zone (45) dans laquelle l'ouverture pour les guides optiques (40) du côté de la plaque substrat, après montage, est parallèle et distante verticalement par rapport à l'ouverture du guide optique (46) du côté de la plaque de couverture.

15. Procédé selon l'une des revendications 11 à 14,
    selon lequel,
    les structures de guidage de fibre (14) sont gravées dans la plaque substrat (32) et la plaque de couverture (34) pour que les axes optiques des fibres optiques (50) mises en place soient alignés sur les axes optiques des guides optiques (40, 46) remplissant les ouvertures.

16. Procédé selon l'une des revendications 11 à 15,
    selon lequel,
    les structures d'ajustage (36) sont gravées plus à plat de la valeur afin que les structures de guidage de fibre (14) soient gravées plus profondément.

17. Elément de couplage optique comprenant une plaque substrat (32) en polymère dans laquelle est réalisée au moins une paire de structures d'ajustage (36), une paire de structures de guidage (14) pour recevoir les fibres à coupler ainsi qu'un premier guide d'onde (40), le guide d'onde (40) reliant les deux structures de guidage, une plaque de couverture (34) en polymère dans laquelle on a au moins une paire de structures d'ajustage (36), une paire de structures de guidage (14) pour recevoir les fibres à coupler ainsi qu'un second guide d'onde (46), le guide d'onde (46) reliant entre elles les deux structures de guidage (14) et les deux plaques polymères (32, 34) sont réunies pour que chaque fois une structure d'ajustage (36) et une structure de guidage (14) forment une cavité (44) de section en losange, continue pour recevoir des fibres optiques, et chaque fois l'un des guides (40, 46) entoure le centre du losange et le premier guide optique (40) et le second guide optique (46) sont parallèles au moins dans une zone (45) et forment une structure de couplage à intégration verticale.

18. Elément de couplage optique selon la revendication 17,
selon lequel,
entre la plaque substrat (32) en polymère et la plaque de couverture en polymère (34) on a une feuille tampon (42) qui recouvre au moins partiellement les plaques en polymère (32, 34), au moins dans la zone des guides d'onde (40, 46).

19. Elément de couplage optique selon la revendication 18,
selon lequel,
dans la feuille tampon (42) on a des électrodes qui se trouvent à côté de la zone (45) du guide d'onde.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13